# EUROPÄISCHE PATENTANMELDUNG

(11) **EP 3 410 505 A1**
(43) Veröffentlichungstag der Anmeldung: **05.12.2018**
(21) Anmeldenummer: 17173859.4
(22) Anmeldetag: 31.05.2017
(51) Int. Cl.: H01L 51/42, H01L 51/46

(54) **POLYPHENOLE UND POLYAMINO-DERIVATE IN ORGANISCHEN OPTOELEKTRONISCHEN BAUELEMENTEN**

(71) Anmelder: Heliatek GmbH, 01139 Dresden (DE)
(72) Erfinder: Mattersteig, Gunter, 89077 Ulm (DE); Levichkova, Marieta, 01139 Dresden (DE); Walzer, Karsten, 01139 Dresden (DE); Pfeiffer, Martin, 01139 Dresden (DE); Gerdes, Olga, 89077 Ulm (DE); Hildebrandt, Dirk, 89077 Ulm (DE); D'Souza, Daniel, 01139 Dresden (DE); Weiß, Andre, 01139 Dresden (DE); Mirloup, Antoine, 89077 Ulm (DE)

(57) **Zusammenfassung**

Die Erfindung beschreibt die Verwendung von Polyphenolen und Polyamino-Derivaten angrenzend an Absorberschichten in organischen optoelektronischen Bauelementen.

## Beschreibung

### Gebiet der Erfindung

Die Erfindung beschreibt optoelektronische Bauelemente, speziell organische optoelektronische Bauelemente, mit Polyphenolen und Polyamino-Derivaten.

### Stand der Technik

Organische optoelektronische Bauelemente ermöglichen es beispielsweise als Solarzelle unter Ausnutzung des photoelektrischen Effekts Licht in elektrischen Strom umzuwandeln. Für die Umwandlung werden organische Halbleitermaterialien benötigt, die hinreichend gute Absorptionseigenschaften besitzen. Diese Absorbermaterialien sind bevorzugt kleine organische Moleküle, deren optische und elektronische Eigenschaften stark von der Orientierung dieser Moleküle abhängen.

Um effiziente organische photoaktive Bauelemente herzustellen, bestehen diese oft aus mehreren gestapelten Zellen in einer Tandem- oder Mehrschichtstruktur zwischen zwei Elektroden, wobei die photoaktiven Schichten, d.h. die Schichten einer Zelle, die Licht absorbieren und einen Beitrag zur Stromgewinnung beitragen, ebenfalls aus mehreren Schichten bestehen können. Das organische optoelektronische Bauelement, kann in einer Zelle neben den photoaktiven Schichten, beispielsweise noch dotierte und undotierte Ladungsträgertransportschichten, und/oder Passivierungsschichten umfassen. Als photoaktive Materialien können Donor- und Akzeptormaterialien auf Basis kleiner Moleküle verwendet werden. Eine photoaktive Schicht in einem photoaktiven Schichtstapel einer Zelle kann nur ein Akzeptor- oder nur ein Donor-Absorbermaterial umfassen oder auch eine Kombination mehrerer Absorbermaterialien unterschiedlichen Typs umfassen. Weiterhin können den Absorberschichten Materialien zugesetzt werden, um die Absorptionseigenschaften zu verbessern. Absorbermaterialien auf Basis kleiner Moleküle sind beispielsweise in WO 2006 092 134, WO 2011 161 262 oder WO 2014 128 277 beschrieben. Organische optoelektronische Bauelemente sind beispielsweise in WO 2004 083 958 oder WO 2011 138 021 offengelegt.

Eine besonders starke Lichtabsorption wird erzielt, wenn sich die molekularen Übergangsdipolmomente der Absorbermoleküle orthogonal zur einfallenden Lichtwelle anordnen Neben der Lichtabsorption ist auch der Ladungstragsport aus dem Absorbermolekül in die angrenzenden Schichten hin zu den Elektroden wichtig. Dieser wird besonders groß, wenn sich die in den Absorbern vorhandenen pi-Elektronensysteme mit dem pi-Elektronensystemen der darunter liegenden Schichte überlappen. Diese Anordnung bezeichnen wir als "face-on" liegend. Diese Anordnung ist bevorzugt. Im Gegensatz dazu ist die Anordnung, die als "edge-on" liegend bezeichnet wird, bei der zwar der molekulare Dipol ebenso wie bei "face-on" orthogonal zur einfallenden Lichtwelle ist, jedoch die pi-Elektronensysteme des Absorbers orthogonal zur unterliegenden Schicht angeordnet sind, was einen effektiven Ladungsübertrag zwischen den pi-Elektronensystemen unterdrückt. Das Wachstum der Absorbermaterialien auf Substraten oder anderen Schichten wird bestimmt durch zwischenmolekulare Kräfte, die einerseits die Wachstumsrichtung und die Orientierung der angrenzenden Moleküle zueinander bestimmen. Dazu ist es möglich eine, orientierungsbildende Schicht, die auch als Templatschicht bezeichnet wird, einzufügen.

Die Erfinder haben festgestellt, dass einzelne Absorbermaterialien, überwiegend Donormaterialien, Probleme mit einer "face-on" Ausrichtung, d.h. einer Ausrichtung orthogonal zur einfallenden Lichtwelle, haben können. Solche Donormaterialien umfassen, beispielsweise heterocyclische Ringe, wie beispielsweise Phthalocyanine, Thiophen-, Furan und/oder Pyrrolringe, und sind bevorzugt Akzeptor-Donor-Akzeptor-Verbindungen, wie sie beispielsweise in WO 2006 092 134 offengelegt sind. Durch die häufig nicht "face-on" wachsende Ausrichtung der Absorbermaterialien, wird in der mit diesen Materialien hergestellten Solarzelle keine optimale Nutzung dieser Absorbermaterialien erreicht.

WO 2011 025 567 offenbart organische optoelektronische Bauelemente, die aus einer strukturbildenden Schicht auf einer Elektrodenschicht bestehen, auf der dann ein photoaktives Schichtsystem aus Akzeptor- und Donormolekülen aufgebracht ist, so dass durch die angrenzende strukturbildende Schicht eine geordnete molekulare Ausrichtung des Akzeptor- oder Donormaterials erfolgt. WO 2011 025 567 schlägt als strukturbildende Materialien Acene, Perylene, beispielsweise Diindenoperylene (DIP) oder 3,4,9,10-perylene-tetracarboxylicaciddianhydride (PTCDA), Polyphenylene, oder Coronen vor.

US 2002 098 346 offenbart Mehrschichtstrukturen auf einem Substrat, wobei eine erste monomolekulare Schicht ein erstes strukturbildendes Material enthält und die Orientierungsrichtung dieser Schicht definiert, wobei ein chemisch reaktives Monomer zu einer gerichteten chemischen Reaktion auf der Oberfläche führt und damit eine geordnete Molekülstruktur erzielt. Dadurch ist US 2002 098 346 in seiner Anwendbarkeit beschränkt auf Stoffe, die chemisch reagieren können. Sie ist nicht anwendbar auf reine Physisorption ohne chemische Reaktion.

### Darstellung der Erfindung

### Technische Aufgabe

Ziel der vorgelegten Erfindung ist, Materialien anzugeben, die zu einer verbesserten Orientierung der Absorbermoleküle in der photoaktiven Schicht, auch als Absorberschicht bezeichnet, führen und damit eine Erhöhung des Kurzschlussstroms ermöglichen, wobei die Leerlaufspannung des optoelektronischen Bauelements zumindest nicht verringert wird.

### Offenbarung der Erfindung und technischer Wirkung der Erfindung

Die technische Aufgabe wird gelöst durch die Verwendung von Polyphenolen und/oder Polyamino-aromaten oder -heteroaromaten, die an Absorbermaterialien angrenzen, in organischen optoelektronischen Bauelementen, damit ein besseres face-on Wachstum der Absorbermaterialien erreicht wird.

Durch die Beschränkung der US 2002 098 346 in seiner Anwendbarkeit auf Stoffe, die chemisch reagieren können, ist sie nicht anwendbar auf reine Physisorption ohne chemische Reaktion, welche der vorliegenden Erfindung zugrunde liegt.

Als face-on wird hierbei der Fall bezeichnet, bei dem die pi-Elektronensysteme der Materialien der verwendeten Polyphenol-Schicht und/oder Polyaminoderivat-Schicht einen pi-pi-Überlapp mit den pi-Elektronensystem(en) der darauffolgenden Absorberschicht bilden.

Die technische Aufgabe wird demnach gelöst mit optoelektronischen Bauelementen die Verbindungen der Struktur (I) umfassen, die an Absorbermaterialien angrenzen: 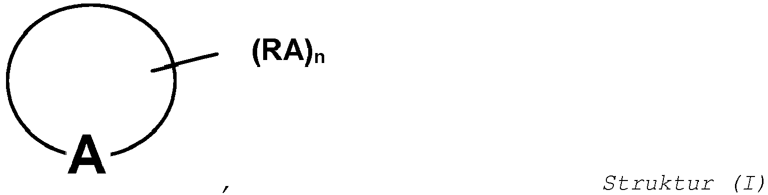
- wobei A den Rest eines Zyklus symbolisiert, der ganz oder teilweise ein carbocyclisches oder heterocyclisches aromatisches, monocyclisches oder polycyclisches System bildet,
- wobei dieser Zyklus mindestens n > 1 Reste RA umfasst, und diese Reste RA jeweils unabhängig ausgewählt sind aus Hydroxy- und Aminogruppen.

Bevorzugt werden erfindungsgemäß Verbindungen, deren Reste RA aus Hydroxygruppen ausgewählt sind, in den organischen optoelektronischen Bauelementen eingesetzt.

Die Erfinder verstehen unter den erfindungsgemäß eingesetzten Verbindungen bevorzugt Verbindungen der allgemeinen Struktur II: 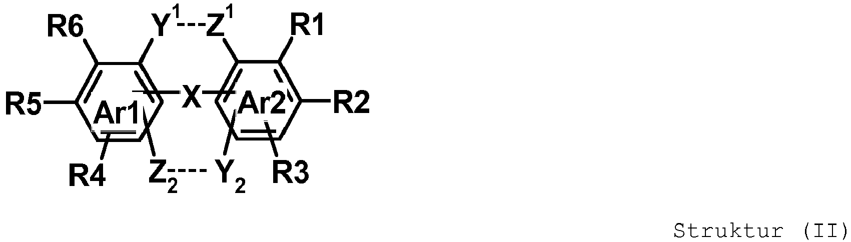
- die zwei oder mehr verbundene aromatischen oder heteroaromatische Ringe (Ar1, Ar2), bevorzugt Benzolringe, besitzen, die jeweils mindestens zwei Hydroxygruppen und/oder Aminogruppen umfassen,
- wobei die aromatischen Ringe (Ar1, Ar2) sowohl durch eine Einfachbindung (-X-) verknüpft als auch direkt anelliert sein können,
- R1 bis R6 ausgewählt sind aus H, OH, NH₂;
- Y1 ausgewählt ist aus CH, CH₂, CO;
- Y2 ausgewählt ist aus CH, CH₂, CO, H;
- Z1 ausgewählt ist aus CH, CH₂, CO, O, NH;
- Z2 ausgewählt ist aus CH, CH₂, CO, O, NH, H;
- wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Bei den anellierten Strukturen handelt es sich vorzugsweise um substituierte Naphthalenderivate (II.1) und Anthracenderivate (11.2), die sowohl verbrückt als auch unverbrückt sein können. Sind YI, ZI oder RI mit I > 1 nicht explizit einer Stelle zugeordnet, können die Substituenten an beliebigen Stellen im zugeordneten Ring, angeordnet sein: 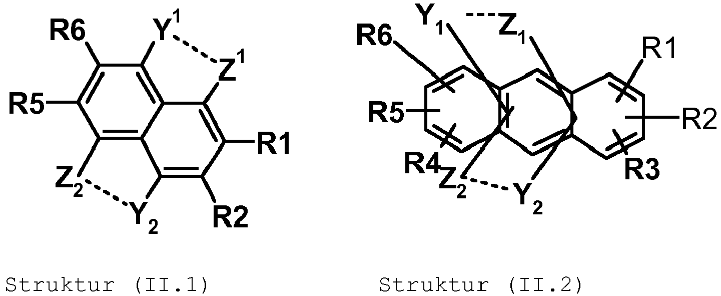
- wobei R1 bis R6 ausgewählt sind aus H, OH, NH₂;
- Y1 ausgewählt ist aus CH, CH₂, CO;
- Y2 ausgewählt ist aus CH, CH₂, CO, H;
- Z1 ausgewählt ist aus CH, CH₂, CO, O, NH;
- Z2 ausgewählt ist aus CH, CH₂, CO, O, NH, H;
- wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Die Verbrückung der aromatischen Ringe (Ar1 und Ar2) gemäß Struktur (II), welche mittels einer Einfachbindung (-X-) verknüpft sind, kann unabhängig
- durch eine oder zwei Doppelbindung(en) unter Bildung eines Phenanthrens oder Pyrens,
- durch einen oder mehrere anellierte aromatische oder heteroaromatische Ringe unter Bildung eines Triphenylens oder Dibenzopyrens,
- durch Alkylgruppen mit ein bis drei C-Atomen,
- durch Aryloxy- oder Arylaminogruppen
- durch Alkoxygruppen unter Bildung von Pyranen, durch Carbonyl-, Carboxy- oder Carbamoylgruppen unter Bildung von Ketonen, Chinonen, Anthrachinonen (11.3), Lactonen und Lactamen, erfolgen. 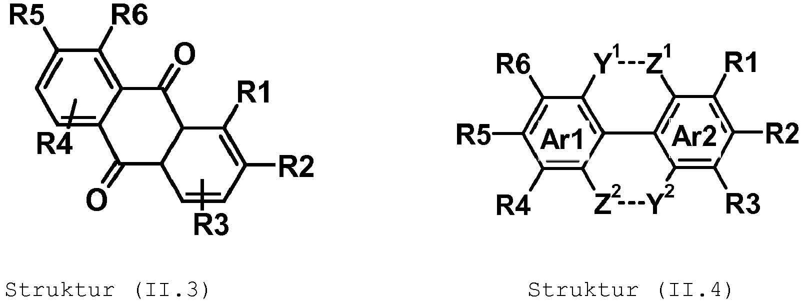
   - wobei Ar1 und Ar2 zwei oder mehr verbundene aromatischen oder heteroaromatische Ringe (Ar1, Ar2), bevorzugt Benzolringe, sind, die jeweils mindestens zwei Hydroxygruppen und/oder Aminogruppen umfassen,
   - R1 bis R6 ausgewählt sind aus H, OH, NH₂;
   - Y1 ausgewählt ist aus CH, CH₂, CO;
   - Y2 ausgewählt ist aus CH, CH₂, CO, H;
   - Z1 ausgewählt ist aus CH, CH₂, CO, O, NH;
   - Z2 ausgewählt ist aus CH, CH₂, CO, O, NH, H;
   - wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Unter bevorzugten erfindungsgemäßen Verbindungen auf der Basis von Polyphenolen werden insbesondere Verbindungen der allgemeinen Struktur (11.4) verstanden, besonders bevorzugt Ellagsäure.

Unter den erfindungsgemäß verwendeten Verbindungen auf Basis von Polyamino-Derivaten werden insbesondere folgende Verbindungen verstanden:
- Polyamino-aromate oder -heteroaromate, beschrieben durch die allgemeine Struktur (I) wobei A den Rest eines Zyklus symbolisiert, der ganz oder teilweise ein carbocyclisches oder heterocyclisches aromatisches, monocyclisches oder polycyclisches System bildet, und wobei dieser Zyklus mindestens 2 Aminogruppen umfasst.

Ebenso wird die technische Aufgabe gelöst nur durch die Zusetzung der erfindungsgemäß vorgeschlagenen Verbindungen als Additive zu einer Absorberschicht.

Als weitere Lösung der technischen Aufgabe ist die Herstellung optoelektronischer Bauelemente umfassend eine der Verbindungen von Polyphenolen und/oder Polyamino-aromaten oder -heteroaromaten, die an Absorbermaterialien angrenzen.

### Vorteilhafte Wirkung der Erfindung

Durch die Verwendung der erfindungsgemäßen Strukturen als Templatschicht erfolgt eine bessere Ausrichtung des angrenzenden, im Anschluss an die Templatschicht aufgebrachten Absorbermaterials, so dass eine bessere Effizienz des optoelektronischen Bauelements erreicht wird.

Für Mehrschicht-OPV (OPV = organische Photovoltaik) wird eine face-on Orientierung der Moleküle erreicht, die eine optimale Lichtabsorption und verbesserte Ladungstransporteigenschaften gewährleisten. In OPV-Bauelementen kann die Erzeugung einer kristallinen Ordnung zu einer Erhöhung des Kurzschlussstromes (Isc) und der Leerlaufspannung (Voc) führen. So kann über die Kontrolle der molekularen kristallinen Orientierung der Absorberschichten, speziell der Donorschicht, eine Optimierung der Grenzorbitalniveaus, des Absorptionskoeffizienten, der Morphologie und der Excitonendiffusionslängen erzielt werden. Damit wird die Effizienz der Energieumwandlung verbessert. Eine pi-Stapel-Anordnung coplanarer, flachliegender Absorbermoleküle, die sich über mehrere Schichten (face-on growth) fortsetzt ist daher sehr erwünscht und wird durch die an die Absorbermaterialien angrenzenden erfindungsgemäßen Verbindungen begünstigt.

Um das Optimum sowohl der Donormolekül-Orientierung als auch der Morphologie zu erreichen, sollte die Templat-Donormolekül-Wechselwirkung sowohl stark genug sein, um eine face-on-Stapelung zu erreichen als auch schwach genug, um Filmrauheiten zu vermeiden. Es soll insbesondere der Ladungstransport senkrecht zum Substrat verbessert werden, was eine Erhöhung des Füllfaktors bewirkt, bzw. bei gleichbleibendem Füllfaktor höhere Schichtdicken ermöglicht, so dass somit mehr Photostrom generiert wird.

Die erfindungsgemäße Verwendung der Verbindungen mit obigem Substituentenmuster bilden über starke Wasserstoff-Brückenbindungen und bei gleichzeitig abgeschwächter pi-Stapelwechselwirkung Schichten mit flachliegenden Molekülen (face-on, horizontale Ausrichtung) im Unterschied zu Phthalocyaninen, Hexabenzocoronen und anderen mehrfach aromatisch und heteroaromatisch anellierten Scheibenmolekülen, bei denen durch die starke pi-pi-Stapelwechselwirkung der Moleküle untereinander diese coplanar stehen und sich senkrecht aufrichten (edge-on, vertikale Ausrichtung).

Die Erfinder zeigen am Beispiel einer Templatschicht, umfassend Ellagsäure, die eine der erfindungsgemäßen Verbindungen gemäß einer der oben genannten Strukturen darstellt, und vor der Absorberschicht auf den Schichtstapel aufgebracht wurde, dass Solarzellen mit Templatschicht einen höheren Wirkungsgrad als adäquate Solarzellen ohne Templatschicht haben.

Weiterhin konnten die Erfinder überraschend feststellen, dass Solarzellen sogar nur mit einer dünnen Templatschicht einen höheren Wirkungsgrad als identische Solarzellen ohne Templatschicht besitzen und gleichzeitig die Lebensdauer der Solarzellen erhöht werden kann.

### (Kurze Beschreibung der Zeichnungen)

Die Erfindung und die Ausführungsbeispiele werden mit Zeichnungen beschrieben. Die einzelnen Zeichnungen stellen dar:
- Fig. 1:: Röntgendiffraktogramm einer Templatschicht.
- Fig. 2, Fig. 3, Fig. 4:: Röntgendiffraktogramme von Proben mit und ohne Templatschicht
- Fig. 5, Fig. 6, Fig. 7, Fig. 8:: Strom-Spannungskurven von Solarzellen mit und ohne Templatschicht
- Fig. 9:: Beschleunigte Lebensdauermessung von Solarzellen mit und ohne einer Templatschicht
- Fig. 10:: Liste der in den Ausführungsbeispielen genannten Absorbermaterial-Moleküle
- Fig. 11:: 2D-Anordnungen von möglichen weiteren Materialien in einer Templatschicht

### Detaillierte Beschreibung der Erfindung

Die technische Aufgabe wird gelöst durch die Verwendung von Polyphenolen und/oder Polyamino-aromaten oder -heteroaromaten, die an Absorbermaterialien angrenzen, in organischen optoelektronischen Bauelementen, damit ein besseres face-on Wachstum der Absorbermaterialien erreicht wird.

Analog wird die technische Aufgabe gelöst eine Schicht umfassend Polyphenole und/oder Polyamino-aromaten oder -heteroaromaten, wobei diese Verbindungen an Absorbermaterialen angrenzen und ein besseres face-on-Wachstum der Absorbermaterialien ermöglichen.

Die technische Aufgabe wird demnach gelöst mit optoelektronischen Bauelementen die Verbindungen der Struktur (I) umfassen, die an Absorbermaterialien angrenzen: 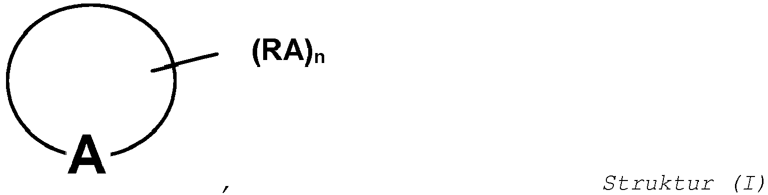
- wobei A den Rest eines Zyklus symbolisiert, der ganz oder teilweise ein carbocyclisches oder heterocyclisches aromatisches, monocyclisches oder polycyclisches System bildet,
- wobei dieser Zyklus mindestens n > 1 Reste RA umfasst, und diese Reste RA jeweils unabhängig ausgewählt sind aus Hydroxy- und Aminogruppen.

In einer Ausführungsform sind die organische optoelektronische Bauelemente mit mindestens einer der erfindungsgemäß vorgeschlagenen Verbindungen angrenzend an Absorbermaterialien auf der Basis kleiner Moleküle, vorzugsweise angrenzend an Absorbermaterialien auf Basis A-D-A (Akzeptor - Donor - Akzeptor) oder D-A-D (Donor - Akzeptor - Donor). Die photoaktiven Schichten, die die Absorbermaterialien umfassen, können als
- Kombination von Einzelschichten, wobei eine Schicht mit einem Donormaterial an mindestens eine Schicht mit einem Absorbermaterial angrenzt, oder
- als Bulk heterojunction Schichten ausgeführt sein,
- oder eine Kombination aus beiden.

In einer Ausführungsform umfasst das optoelektronische Bauelement eine separate Schicht, als Templatschicht bezeichnet, umfassend die erfindungsgemäß verwendeten Verbindungen, wobei diese Templatschicht vor der angrenzenden photoaktiven Schicht, umfassend mindestens ein Absorbermaterial, prozessiert wurde.

In einer weiteren Ausführungsform sind die erfindungsgemäß verwendeten Verbindungen als Additive mindestens einer Absorberschicht zugefügt.

In einer weiteren Ausführungsform können innerhalb eines Tandem- oder Mehrschichtelements nur eine Zelle eine der vorgeschlagenen Verbindungen umfassen, oder in mindestens zwei Zellen gleiche und/oder verschiedenen der vorgeschlagenen Verbindungen verwendet werden.

In einer Kombination der obigen Ausführungsformen ist es möglich, dass eine Subzelle auch mehrere Templatschichten innerhalb ihres photoaktiven Schichtsstapels umfasst, wobei die Templatschichten gleiche oder unterschiedliche Materialien umfassen können. In einer adäquaten Ausführungsform können in dem optoelektronischen Bauelement die Templatschichten teilweise oder vollständig als Additiv-Zusatz zur Absorberschicht verstanden werden.

Bevorzugt werden erfindungsgemäß cyklische Verbindungen, deren Reste RA = Hydroxygruppen sind, in den organischen optoelektronischen Bauelementen eingesetzt.

Die Erfinder verstehen unter den erfindungsgemäß eingesetzten Verbindungen bevorzugt Verbindungen der allgemeinen Struktur II: 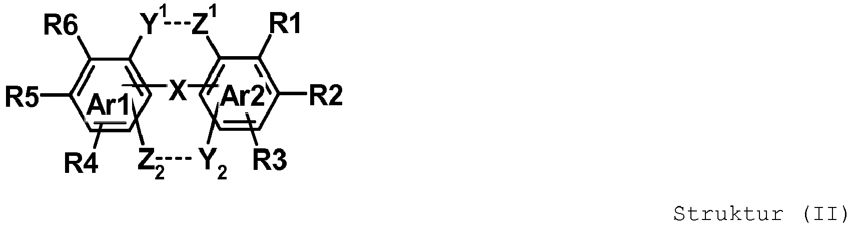
- die zwei oder mehr verbundene aromatischen oder heteroaromatische Ringe (Ar1, Ar2), bevorzugt Benzolringe, besitzen, die jeweils mindestens zwei Hydroxygruppen und/oder Aminogruppen umfassen,
- wobei die aromatischen Ringe (Ar1, Ar2) sowohl durch eine Einfachbindung (-X-) verknüpft, als auch direkt anelliert sein können,
- R1 bis R6 ausgewählt sind aus H, OH, NH₂;
- Y1 ausgewählt ist aus CH, CH₂, CO;
- Y2 ausgewählt ist aus CH, CH₂, CO, H;
- Z1 ausgewählt ist aus CH, CH₂, CO, O, NH;
- Z2 ausgewählt ist aus CH, CH₂, CO, O, NH, H;
- wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Bei den anellierten Strukturen bilden sich vorzugsweise substituierte Naphthalenderivate (II.1) und Anthracenderivate (11.2) aus, die sowohl verbrückt als auch unverbrückt sein können. Sind YI, ZI oder RI mit I > 1 nicht explizit, einer Stelle zugeordnet, können die Substituenten an beliebigen Stellen im zugeordneten Ring, angeordnet sein: 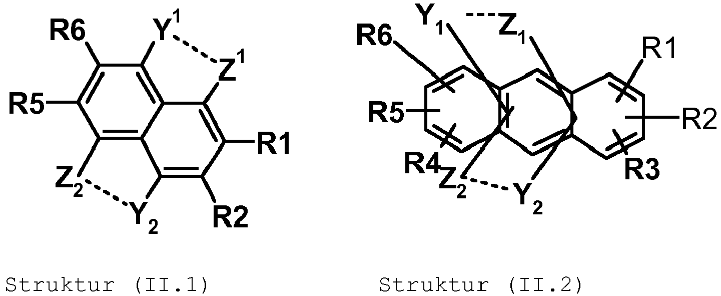
- wobei R1 bis R6 ausgewählt sind aus H, OH, NH₂;
- Y1 ausgewählt ist aus CH, CH₂, CO;
- Y2 ausgewählt ist aus CH, CH₂, CO, H;
- Z1 ausgewählt ist aus CH, CH₂, CO, O, NH;
- Z2 ausgewählt ist aus CH, CH₂, CO, O, NH, H;
- wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Die Verknüpfung der aromatischen Ringe (Ar1 und Ar2) gemäß Struktur (II), welche mittels einer Einfachbindung (-X-)verknüpft sind, kann unabhängig
- durch eine oder zwei Doppelbindung(en) unter Bildung eines Phenanthrens oder Pyrens,
- durch einen oder mehrere anellierte aromatische oder heteroaromatische Ringe unter Bildung eines Triphenylens oder Dibenzopyrens,
- durch Alkylgruppen mit ein bis drei C-Atomen,
- durch Aryloxy- oder Arylaminogruppen
- durch Alkoxygruppen unter Bildung von Pyranen, durch Carbonyl-, Carboxy- oder Carbamoylgruppen unter Bildung von Ketonen, Chinonen, Anthrachinonen (11.3), Lactonen und Lactamen, erfolgen. 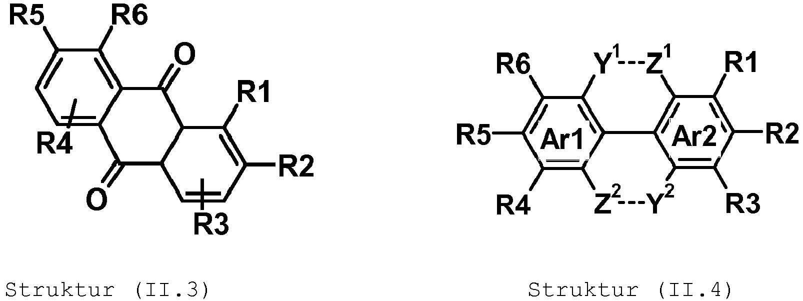
   - wobei Ar1 und Ar2 zwei oder mehr verbundene aromatischen oder heteroaromatische Ringe (Ar1, Ar2), bevorzugt Benzolringe, sind, die jeweils mindestens zwei Hydroxygruppen und/oder Aminogruppen umfassen,
   - R1 bis R6 ausgewählt sind aus H, OH, NH₂;
   - Y1 ausgewählt ist aus CH, CH₂, CO;
   - Y2 ausgewählt ist aus CH, CH₂, CO, H;
   - Z1 ausgewählt ist aus CH, CH₂, CO, O, NH;
   - Z2 ausgewählt ist aus CH, CH₂, CO, O, NH, H;
   - wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Unter bevorzugten erfindungsgemäßen Verbindungen auf der Basis von Polyphenolen werden insbesondere Verbindungen der allgemeinen Struktur (II.4) verstanden.

Unter den erfindungsgemäß verwendeten Verbindungen auf Basis von Polyamino-derivaten werden insbesondere folgende Verbindungen verstanden:
- Polyamino-aromate oder -heteroaromate, beschrieben durch die allgemeine Struktur (I) wobei A den Rest eines Zyklus symbolisiert, der ganz oder teilweise ein carbocyclisches oder heterocyclisches aromatisches, monocyclisches oder polycyclisches System bildet, und wobei dieser Zyklus mindestens 2 Reste auf Basis von Aminogruppen umfasst.

Beispiele für erfindungsgemäße verwendete Polyphenole sind in Tabelle 1 gezeigt.

### Tabelle 1:

(In den beiden unteren linken Verbindungen können die Hydroxy- oder Aminogruppen, die jeweils mit einem in den Ring hineinreichenden Strich angefügt sind, unabhängig an jeder der Stellen ohne vorgegebenen Substituent angefügt sein.)

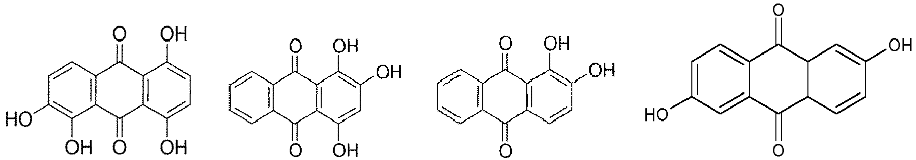

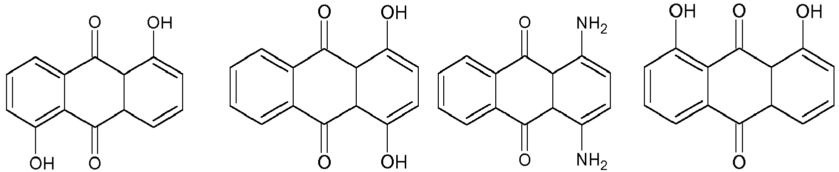

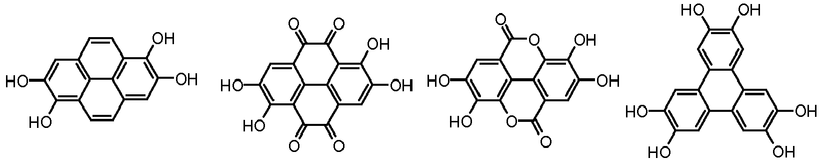

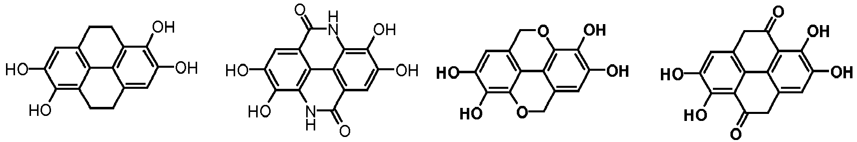

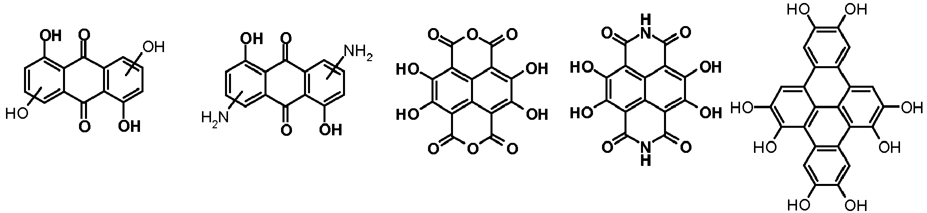

Als weitere erfindungsgemäß verwendbare Verbindungen gemäß der Struktur (I) werden folgende Verbindungen angegeben:

### Tabelle 2

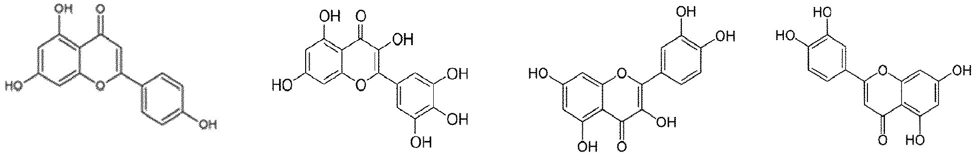

Die meisten der in den beiden Tabellen benannten Verbindungen sind bekannt und käuflich erwerbbar.

Die Erfinder konnten überraschend feststellen, dass ebenso folgende natürliche Stoffe als Verbindungen zur Lösung der technischen Aufgabe geeignet erscheinen, weil diese ebenfalls eine entsprechende Anordnung begünstigen:

### Tabelle 3:

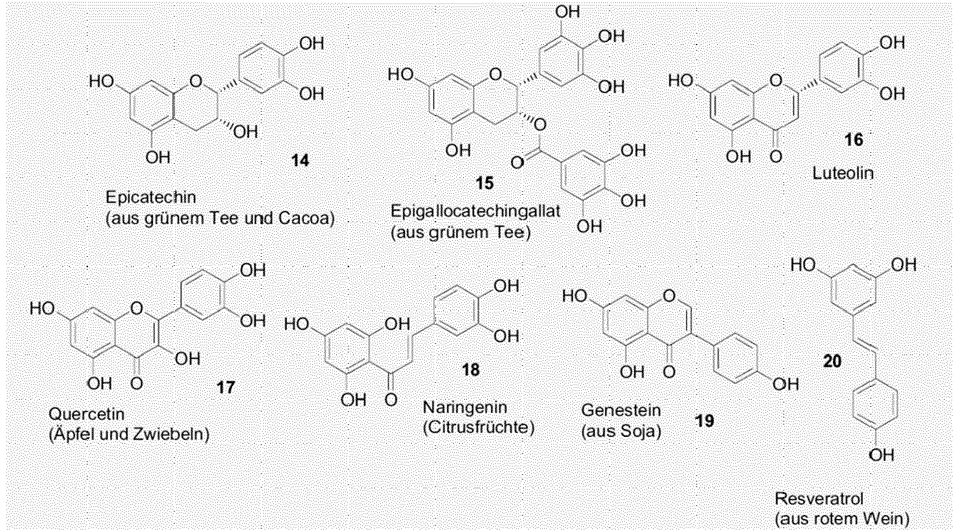

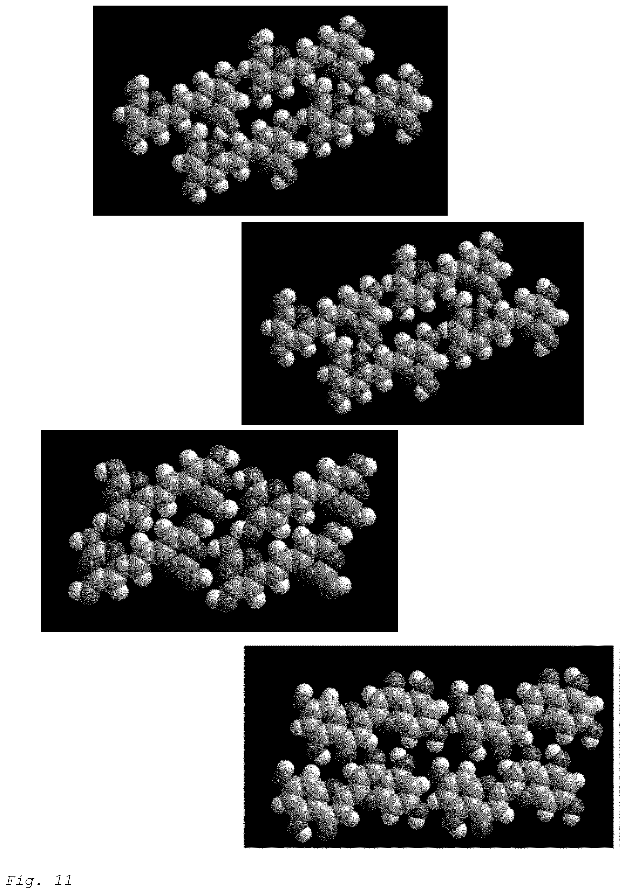

Weiterhin werden folgende Materialien vorgeschlagen, die sich durch eine Kombination mehrerer OH-Gruppen und mehreren N-H-Brücken je Molekül auszeichnen. Fig. 11 verdeutlicht die 2D-Anordnung einiger Materialien der folgenden Tabelle 4.

### Tabelle 4

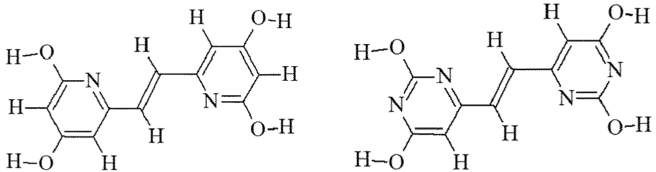

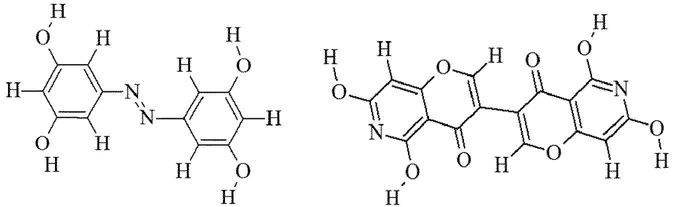

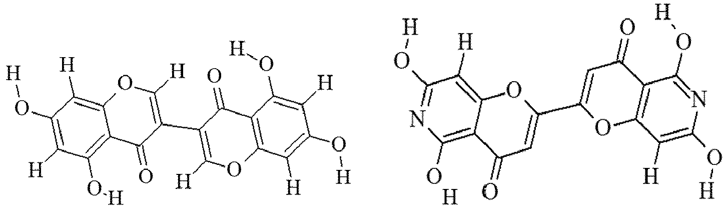

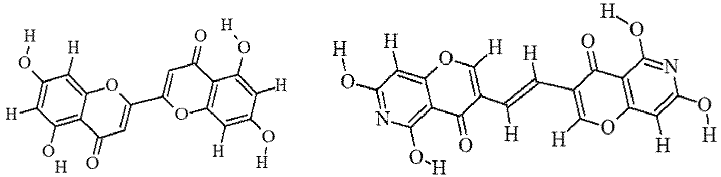

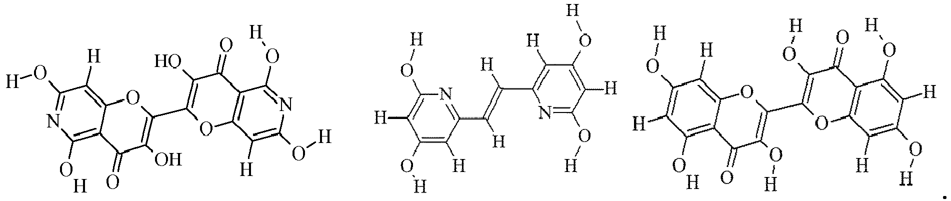

Weiterhin erfindungsgemäß ist die Herstellung organischer optoelektronischer Bauelemente mit Verbindungen gemäß einer der Strukturen (I), (II), (II.1), (11.2), (11.3) oder (11.4) oder der vorgenannten Tabellen. Dem Fachmann sind die Schritte für die Herstellung organische optoelektronische Bauelemente bekannt. Deshalb ist erfindungsgemäß der zusätzliche Schritt bei dem, vor dem Auftragen mindestens einer Absorberschicht eine Templatschicht, umfassend mindestens eine der erfindungsgemäßen Verbindung auf den bisher prozessierten Schichtstapel, aufgebracht wird und danach erst die Absorberschicht aufgebracht wird. Dieser Schritt kann bei weiteren Absorberschichten innerhalb eines Schichtstapels des optoelektronischen Bauelements, sowohl innerhalb nur einer Zelle als auch in verschiedenen Zellen, wiederholt werden, wobei unterschiedliche oder gleiche Materialien in den Templatschichten verwendet werden können.

Alternativ kann mindestens eine erfindungsgemäße Verbindung auch gemeinsam mit einer oder mit mehreren Absorberschichten aufgebracht werden.

Das Aufbringen der erfindungsgemäßen Verbindungen kann beispielsweise
- durch Co-Verdampfen mit mindestens einem Absorbermaterial, bei Einsatz als Additive,
- durch Verdampfen vor dem Auftragen der Absorberschicht, bei Einsatz als Templateschicht, oder
- durch Aufbringen aus einer Lösung

### erfolgen.

Eine Templatschicht mit mindestens einer der Verbindungen kann entweder nur in einer Zelle einer Tandem- oder Mehrfachzelle oder in mehreren Zellen einer Tandem- oder Mehrfachzelle vor dem Auftragen des Absorbermaterials in dieser Zelle erfolgen. Dabei können in den einzelnen Zellen, gleiche Templatmaterialien oder unterschiedliche Templatmaterialien vor dem Auftragen der Absorbermaterialien dieser Zelle beim Aufbau des Schichtstapels aufgetragen werden.

In weiteren Ausführungsform umfasst das organischen optoelektronischen Bauelement innerhalb einer Zelle einer Einzel-, Tandem- oder Mehrfachzelle mehrere Schichten mit gleichen oder unterschiedlichen erfindungsgemäßen Verbindungen.

Weiterhin erfindungsgemäß ist die Verwendung der Verbindungen gemäß der Strukturen (I), (II), (II.1), (II.2), (11.3) oder (II.4), in organischen optoelektronischen Bauelementen, wobei diese Materialien an mindestens ein Absorbermaterial einer photoaktiven Schicht grenzen.

Bevorzugt ist die Verwendung von Verbindungen gemäß der Struktur (11.4), oder Verbindungen gemäß der Tabelle 1, besonders bevorzugt ist die Verwendung von Ellagsäure.

In einer Ausführungsform erfolgt die Verwendung mindestens einer der eben genannten Materialien in einer Templatschicht, die direkt an eine anschließend aufgebrachte Absorberschicht grenzt.

Besonders bevorzugt ist die Verwendung nur eines erfindungsgemäß genutzten Materials in einer Templatschicht, die an eine anschließend aufgebrachte Absorberschicht grenzt.

### Ausführungsbeispiele

In den folgenden Ausführungsbeispielen wird die funktionelle Eignung der erfindungsgemäß vorgeschlagenen Verbindungen am Beispiel von Ellagsäure gezeigt.

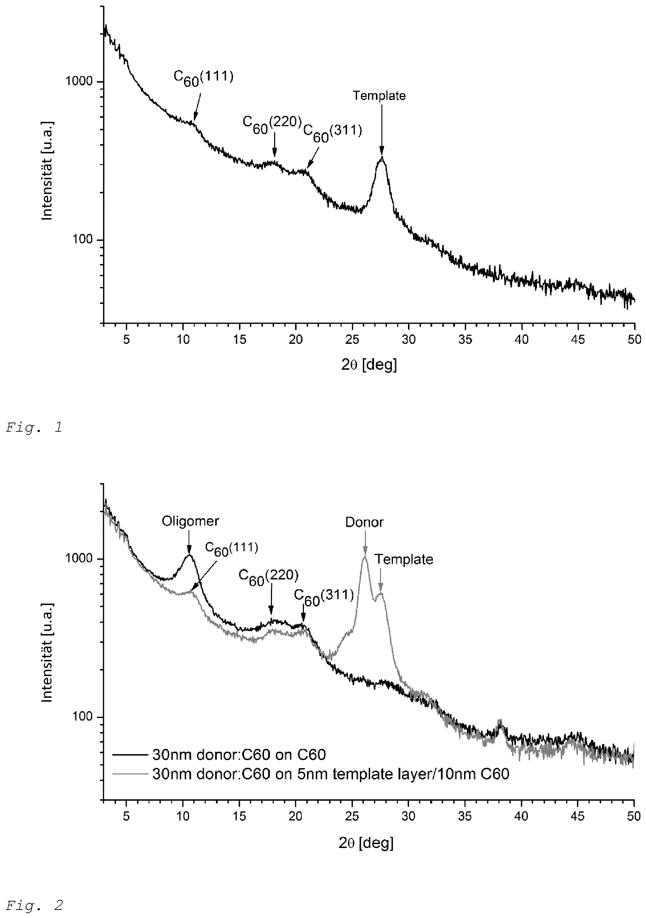

Fig. 1 zeigt das Ergebnis der Röntgendiffraktometrie mit streifendem Einfall (GIXRD) einer 5 nm dicken polyphenolhaltigen Schicht. Die Schichten wurden im Vakuum abgeschieden auf einem mit 10nm C60 beschichteten Si-Wafer.

Die Abscheidung der in Fig. 1 als Templat verwendeten Schicht erfolgte bei Raumtemperatur des Substrates. Die drei Bragg-Reflexe bei 2θ von 10,9°, 18,2° und 20,7° werden der kubischflächenzentrierten Phase (fcc) der C60-Unterschicht zugeordnet [Elschner, C. u.a.: Determining the C60 molecular arrangement in thin films by means of X-ray diffraction. Journal of Applied Crystallography, 44(5):983-990, 2011].

Der Reflex bei 27.6° wird der Templatschicht zugeordnet und deutet darauf hin, dass diese nanokristallin in pi-pi-Stapeln auf C60 wächst. Der Abstand zwischen den Kristallebenen entspricht 3.23 Å. Somit sind die Templatmoleküle parallel zum Substrat ausgerichtet, die pi-pi Stapelrichtung ist senkrecht zum Substrat.

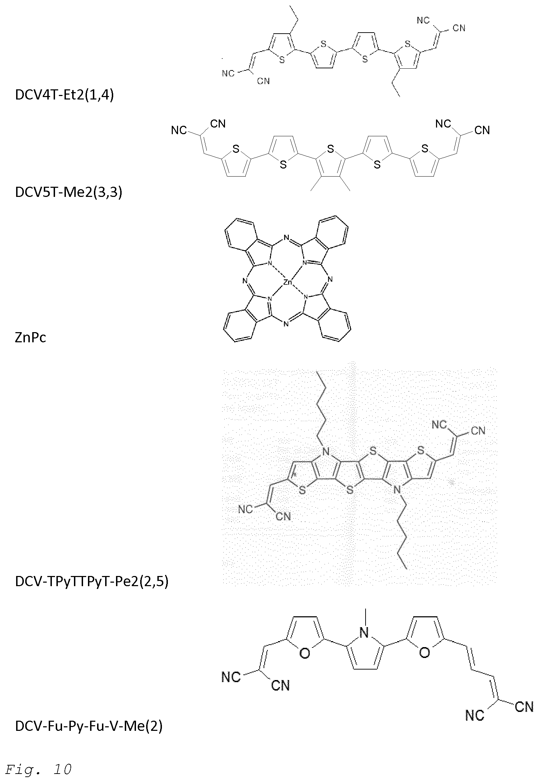

In Fig. 2 sind die Ergebnisse von GIXRD Messungen an einer 30 nm Donor:C60-Mischschicht, mit dem A-D-A-Oligomer DCV4T-Et2, vgl. Fig. 10 als Donor, abgeschieden auf 10 nm C60/Si-Substrat mit und ohne 5 nm Templatschicht dargestellt. Die Donor:C60 Mischschicht wurde bei einer Substrattemperatur von 40°C abgeschieden, das Mischungsverhältnis beträgt 2:1 Masse%. Diese Mischschicht wächst auf C60 nanokristallin.

Der Reflex bei 2θ = 10,8° wurde dem Donor zugeordnet und entspricht einen Abstand zwischen den Kristallebenen von 8,2 Å. Dieser Wert deutet auf Donor-Moleküle hin, die schräg, d.h. edge-on zum Substrat orientiert sind [Guskova, O.: Light absorption in organic solar cells: The importance of oriented molecules, J. Phys. Chem. C, 2013, 117 (33), pp 17285-17293]. Da der (111)-Reflex von C60 bei 2θ = 10,8° liegt, könnte der detektierte Reflex bei 10,8° auch eine Überlagerung von Donor- und C60-Reflex darstellen. Das Röntgendiffraktogramm der Mischschicht aufgewachsen auf der Templatschicht zeigt den für das Templatmolekül Ellagsäure charakteristischen Reflex bei 27.6° (vergl. Fig. 1). Der Donor-Reflex bei 2θ = 10,8° ist nicht mehr vorhanden oder ist signifikant abgeschwächt. Stattdessen zeigt das Diffraktogramm einen neuen starken Reflex bei 2θ = 26,1° und eine Schulter bei 24,6°. Der Kristallebenen-Abstand für den Reflex bei 26,1° entspricht 3,4 Å und deutet somit auf ein face-on Wachstum oder zumindest auf stark zum Substrat gekippte Orientierung der Donormoleküle hin. Die mittlere Größe der Donor-Kristallite wurde mit Hilfe der Scherrer-Gleichung ausgewertet und beträgt 8,1 nm.

Somit beweisen die Messergebnisse, dass die Orientierung der Donor-Moleküle durch die Templatschicht beeinflusst wurde und die Kristallinität der Donor-Phase in der Mischschicht verbessert wurde.

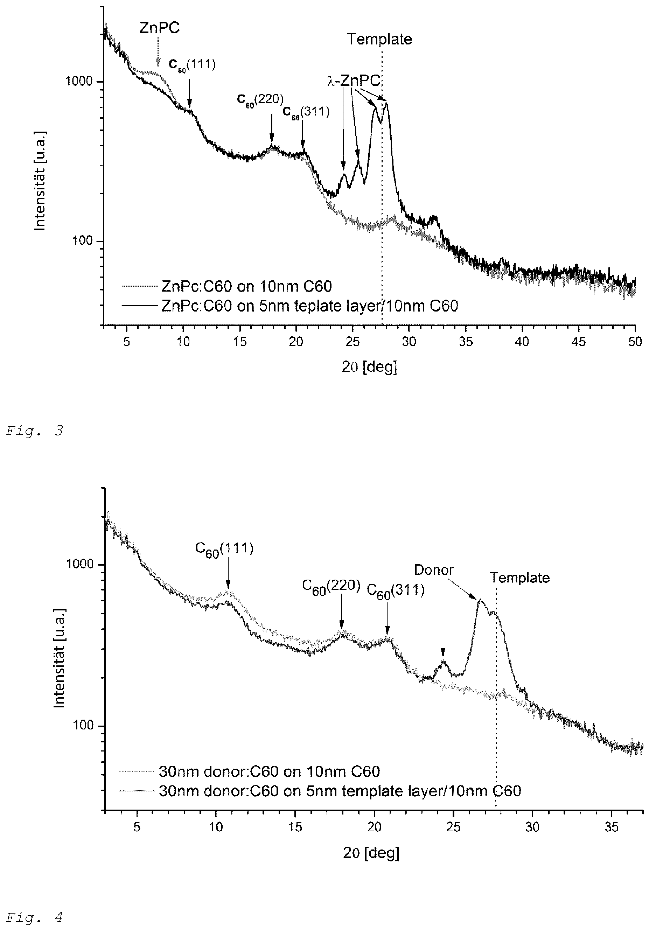

Fig. 3 zeigt Messergebnisse von GIXRD-Untersuchungen an Zink-Phthalocyanin (ZnPc) gemischt mit C60 in einer ZnPc:C60 Mischschicht, gewachsen auf 10 nm C60/Si-Substrat mit und ohne 5 nm Templatschicht. Die 30 nm dicken Mischschichten wurden auf 70°C geheiztem Substrat abgeschieden, das Mischungsverhältnis beträgt 1:1. Für beide Proben sind die drei charakteristische Reflexe der kubisch-flächenzentrierte (fcc) Phase der C60-Unterschicht bei 2θ = 10,9°, 18,2°, 20,7° gut erkennbar. Die ZnPc:C60 Mischschicht abgeschieden direkt auf C60 zeigt zwei amorphe ZnPc-Signale bei 2θ = 7,7° und 2θ = 28,6°. Bei der auf der Templatschicht abgeschiedenen Probe verschwindet die Charakteristik bei 7,7° und neue Bragg-Reflexe bei größeren 2θ-Winkeln zwischen 24° und 29° treten auf. In Fig. 3 sind diese mit λ-ZnPc bezeichnet. Die Zuordnung der Reflexe erfolgte anhand der Veröffentlichung von [Schünemann, C. u.a.: Evaluation and Control of the Orientation of Small Molecules for Strongly Absorbing Thin Films. The Journal of Physical Chemistry C 2013, 117, 11600-11609]. Die mit λ bezeichneten Reflexe entsprechen auf dem Substrat flach-liegenden ZnPc-Molekülen (face-on-Wachstum). Die berechneten Abstände zwischen parallelen Kristallebenen liegen im Bereich 3.2 Å bis 3.7 Å.

Dementsprechend führt die dünne Templatschicht zur Änderung der Orientierung von stehend nach face-on und zur Verbesserung der Kristallinität der ZnPc-Moleküle.

Fig. 4 stellt Ergebnisse der GIXRD Messungen an Donor:C60 Mischschichten, mit DCV5T-Me2(3,3) als Donor, abgeschieden auf 10 nm C60 mit und ohne Templatschicht dar. Die 30 nm dicken Mischschichten wurden auf 80°C geheiztem Substrat abgeschieden, das Mischungsverhältnis beträgt 2:1. Das Röntgendiffraktogramm zeigt für beide Donor:C60 Mischschichten die charakteristischen Peaks der C60 fcc-Phase. Der Donor in der Mischschicht, aufgedampft direkt auf C60 wächst amorph. Im Gegensatz dazu zeigen sich auf der Templatschicht Reflexe im 2θ-Bereich zwischen 24° und 30°. Diese sind der Donor-Phase in der Mischschicht und der Templatschicht zugeordnet. Dementsprechend wächst der Donor auf der Templatschicht kristallin. Die Reflexe zwischen 24° und 30° entsprechen Bragg-Abständen von 3,7 Å und 3,4 Å.

Diese Werte deuten auf flach-liegende (face-on) oder zumindest stark zum Substrat geneigte Donormoleküle hin.

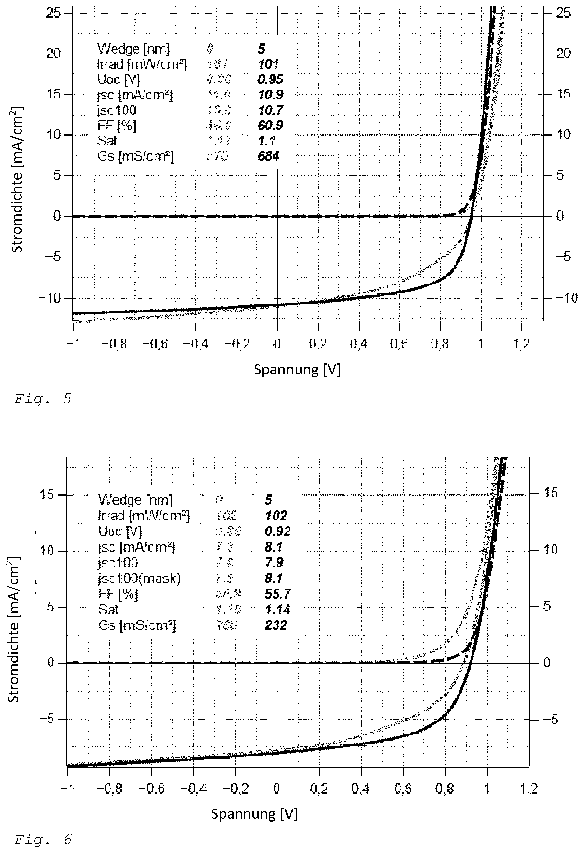

Fig. 5 sind die Messergebnisse von Solarzellen dargestellt, die eine photoaktiven Schicht aus Donor:C60 (Donor = DCV4T-Et2) enthalten. Die photoaktive Schicht weist eine Dicke von 30 nm auf. Die Abscheidung der photoaktiven Schicht erfolgte bei einer Substrattemperatur von 40°C. Das Mischungsverhältnis zwischen Donor und C60 beträgt 2:1. Die grau dargestellte Kurve zeigt die Strom-Spannungskennlinie eines Bauelements, in dem die photoaktive Schicht direkt auf C60 abgeschieden wurde und die schwarz dargestellte Kurve zeigt die Strom-Spannungskennlinie eines Bauelements mit photoaktiver Schicht abgeschieden auf einer 5 nm dicken Templatschicht. Für die Zelle mit der Templatschicht zeigt sich eine Erhöhung des Füllfaktors um 13,6% (von 45,2% auf 58,8%). Diese ist in Übereinstimmung mit den Ergebnissen der GIXRD Messung (Fig. 2) auf die verbesserte Kristallinität der photoaktiven Schicht zurückzuführen. Die Templatschicht führt folglich zu einer deutlich verbesserten Solarzelle.

Fig. 6 zeigt die Messergebnisse von zwei Solarzellen mit einer photoaktiven Schicht von Donor:C60 (DCV4T-Et2:C60). Die photoaktive Schicht weist eine Dicke von 30 nm auf. Ihre Abscheidung erfolgte bei einer Substrattemperatur von 70°C. Die graue Kennlinie zeigt die Strom-Spannungskennlinie des Bauelements, bei dem die Donor:C60-Schicht direkt auf C60 abgeschieden wurde und die schwarze Kennlinie zeigt die Strom-Spannungskennlinie eines Bauelements mit Donor:C60 Schicht abgeschieden auf einer 5nm dicken Templatschicht. Der Füllfaktor der Solarzelle mit der Templatschicht liegt bei 55,7%, im Vergleich dazu hat die Solarzelle ohne Templatschicht einen geringeren Füllfaktor von 44,9%.

Der Anstieg des Füllfaktors ist bedingt durch die verbesserte Nahordnung der Donor-Phase in der photoaktiven Schicht, gewachsen auf der Templatschicht. Mit Templat steigt zudem Voc, lediglich Jsc sinkt leicht. Insgesamt verbessert sich durch das Templat die Zelleffizienz PCE = Voc * jsc *FF.

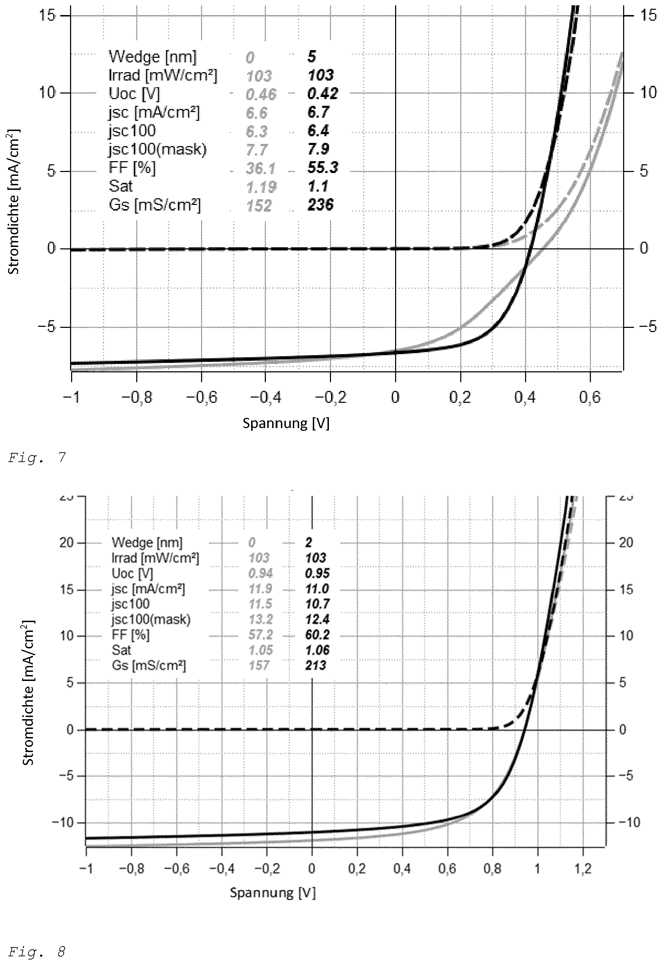

Fig. 7 zeigt die Messergebnisse zweier Solarzellen, die als photoaktive Schicht ZnPc:C60 enthalten. Die photoaktive Schicht weist eine Dicke von 30 nm auf. Ihre Abscheidung erfolgte bei einer Substrattemperatur von 70°C. Die graue Kurve stellt die Strom-Spannungskennlinie des Bauelements dar, in dem die ZnPc:C60-Schicht direkt auf C60 abgeschieden wurde, wogegen die schwarze Kurve die Strom-Spannungskennlinie eines Bauelements mit ZnPc:C60 Schicht, abgeschieden auf einer 5 nm dicken Templatschicht zeigt. Die Solarzelle ohne Templatschicht hat einen Füllfaktor von 36,1%, im Gegensatz dazu hat die Zelle mit Templatschicht einen deutlich besseren Füllfaktor von 55,3%. Gemäß den GIXRD-Daten (siehe Fig. 3) ist der verbesserte Füllfaktor auf die von der Templatschicht hervorgerufene Kristallinität der ZnPc-Phase in der Mischschicht zurückzuführen.

Zwar sinken Voc und jsc leicht, aber der Gesamt-Wirkungsgrad PCE = Voc * jsc * FF wird mit der Templatschicht insgesamt besser.

In Fig. 8 sind die Messergebnisse von Solarzellen, die eine photoaktive Schicht aus Donor:C60 (Donor = DCV-TPyTTPyT-Pe2(2,5)) enthalten dargestellt. Die photoaktive Schicht weist eine Dicke von 30nm auf. Die Abscheidung der photoaktiven Schicht erfolgte bei einer Substrattemperatur von 70°C. Das Mischungsverhältnis zwischen Donor und C60 beträgt 2:1. Die graue Kurve in Fig. 8 zeigt die Strom-Spannungskennlinie eines Bauelements, in dem die photoaktive Schicht direkt auf C60 abgeschieden wurde, und die schwarze Kurve die Strom-Spannungskennlinie eines Bauelements mit einer photoaktiven Schicht abgeschieden auf einer 2 nm dicken Templatschicht. Für die Zelle mit der Templatschicht zeigt sich eine Erhöhung des Füllfaktors im Vergleich zu der Zelle ohne Templatschicht von 57,2% auf 60,2%. Dieses beruht auf einem verbesserten Kristallisationsgrad der Donor-Phase in der Mischschicht, bedingt durch die Wechselwirkung mit der kristallinen Templatschicht. Der Gesamt-Wirkungsgrad PCE = Voc * jsc * FF bleibt hingegen nahezu unverändert, da die Probe mit Templatschicht einen geringeren Strom zeigt.

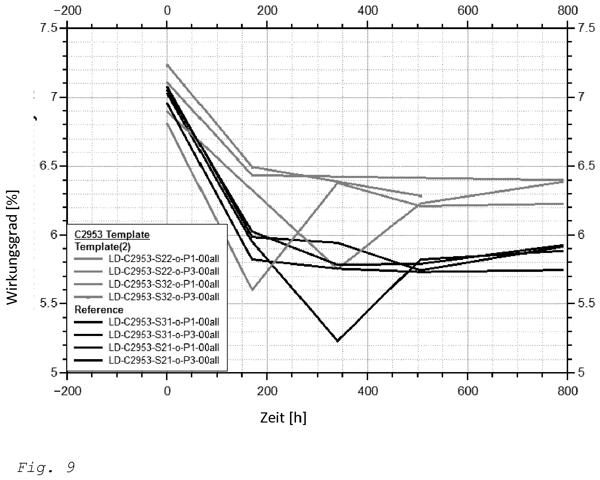

Fig. 9 zeigt als einen überraschenden Befund die Ergebnisse der Lebensdauermessungen von Bulk Heterojunction Solarzellen nach 800 Stunden beschleunigter Alterung im Ofen bei 85°C. Die Solarzellen enthalten als photoaktive Schicht Donor:C60 *(Donor = DCV-Fu-Py-Fu-V-Me(2))* mit Mischungsverhältnis 2:3. Sie sind auf ITO-beschichtetem Glassubstrat hergestellt und haben die Schichtfolge ITO / n-C60 / C60 / Templat (0 oder 2 nm) / Donor:C60 (30 nm) / Lochleiter / p-dotierter Lochleiter / Injektionsschicht / Deck-Elektrode (A1). Die Donor:C60 Mischschicht wurde direkt auf der intrinsischen C60 Schicht oder auf einer Templatschicht abgeschieden.

Für beide Solarzellen wurde einen Initialabfall des Wirkungsgrads beobachtet, danach bleiben die Solarzellen stabil. Der Initialabfall ist mit 17% für die Referenzzellen ohne Templatschicht am stärksten ausgeprägt. Dagegen, beträgt der Abfall für die Solarzellen mit Templatschicht nur 8 %. Die Effizienzabnahme ist auf den Abfall des Füllfaktors zurückzuführen.

Somit deuten die Messergebnisse auf eine stabilisierende Wirkung der Templatschicht auf die Lebensdauer der Solarzellen hin. Eine mögliche Erklärung ist die Ausbildung eines stabileren Füllfaktors durch die bevorzugte Molekülorientierung, die mit dem Templatmaterial erzielt wird.

## Patentansprüche

1. Organisches optoelektronisches Bauelement, umfassend zwei Elektroden und dazwischen angeordnet mindestens ein photoaktives Schichtsystem, dieses umfassend mindestens eine photoaktive Schicht, diese umfassend mindestens ein Absorbermaterialien, **dadurch gekennzeichnet, dass**
∘ mindestens eine Schicht im optoelektronischen Bauelement ein Verbindung der Struktur (I) umfasst: 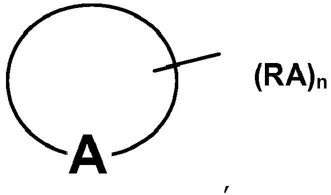
∘ wobei die Verbindungen gemäß der Struktur an ein Absorbermaterial grenzen,
∘ wobei A den Rest eines Zyklus symbolisiert, der ganz oder teilweise ein carbocyclisches oder heterocyclisches aromatisches, monocyclisches oder polycyclisches System bildet,
∘ wobei dieser Zyklus mindestens n > 1 Reste RA umfasst, und diese Reste RA jeweils unabhängig ausgewählt sind aus Hydroxy- und Aminogruppen.

2. Organisches, optoelektronisches Bauelement gemäß Anspruch 1, **dadurch gekennzeichnet, dass** die Schicht umfassend Verbindungen gemäß der Struktur (I) an Absorbermoleküle auf der Basis kleiner Moleküle, bevorzugt sind Absorbermoleküle auf der Basis von A-D-A-Molekülen, grenzt.

3. Organisches optoelektronisches Bauelement nach Anspruch 1 oder 2, **dadurch gekennzeichnet, dass** das Bauelement eine Schicht umfassend mindestens eine Verbindung gemäß Struktur II: 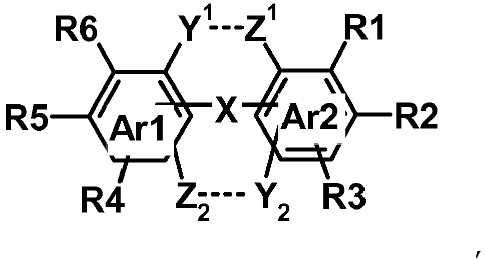 wobei
∘ die substituierten Reste R1 bis R6 ausgewählt sind aus der Gruppe H, OH oder NH₂,
∘ die zwei oder mehr aromatischen Ringe (Ar1, Ar2) unabhängig voneinader ein Aryl oder ein Heterolaryl sind, die mindestens zwei Hydroxygruppen und/oder Aminogruppen umfassen, wobei die aromatischen Ringe (Ar1, Ar2) sowohl durch mindestens eine Einfachbindung als auch direkt anneliert verknüpft sein können,
∘ Y1 ausgewählt ist aus der Gruppe CH, CH₂ oder CO,
∘ Y2 ausgewählt ist aus der Gruppe CH, CH₂, CO oder H
∘ Z1 ausgewählt ist aus der Gruppe CH, CH₂, CO O, oder NH,
∘ Z2 ausgewählt ist aus der Gruppe CH, CH₂, CO, O, NH, oder H;
∘ wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

4. Organisches optoelektronisches Bauelement nach Anspruch 3, **dadurch gekennzeichnet, dass** die Verknüpfung der aromatischen Ringe (Ar1, Ar2) Naphtalenderivate oder Antracenderivate liefert, die verbrückt oder unverbrückt sein können: 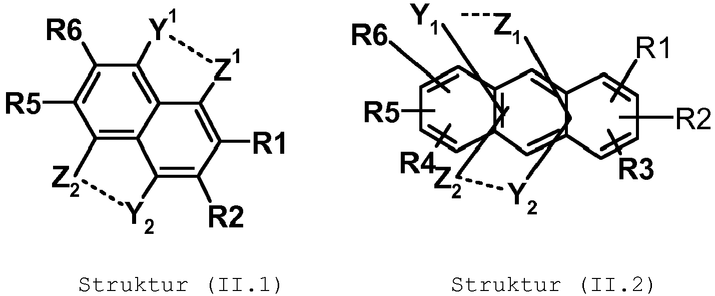
∘ wobei R1 bis R6 ausgewählt sind aus H, OH, NH2;
∘ Y1 ausgewählt ist aus CH, CH2, CO;
∘ Y2 ausgewählt ist aus CH, CH2, CO, H;
∘ Z1 ausgewählt ist aus CH, CH2, CO, O, NH;
∘ Z2 ausgewählt ist aus CH, CH2, CO, O, NH, H;
∘ wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

5. Organisches optoelektronisches Bauelement nach Anspruch 3, **dadurch gekennzeichnet, dass** die Verbrückung der aromatischen Ringe (Ar1, Ar2), die mittels mindestens Einfachbindung (-X-) verknüpft sind, diese Verknüpfung unabhängig erfolgt
∘ durch eine oder zwei Doppelbindung(en) unter Bildung eines Phenanthrens oder Pyrens,
∘ durch einen oder mehrere anellierte aromatische oder heteroaromatische Ringe unter Bildung eines Triphenylens oder Dibenzopyrens,
∘ durch Alkylgruppen mit ein bis drei C-Atomen,
∘ durch Aryloxy- oder Arylaminogruppen
∘ durch Alkoxygruppen unter Bildung von Pyranen, durch Carbonyl-, Carboxy- oder Carbamoylgruppen unter Bildung von Ketonen, Chinonen, Anthrachinonen (II.3), Lactonen und Lactamen: 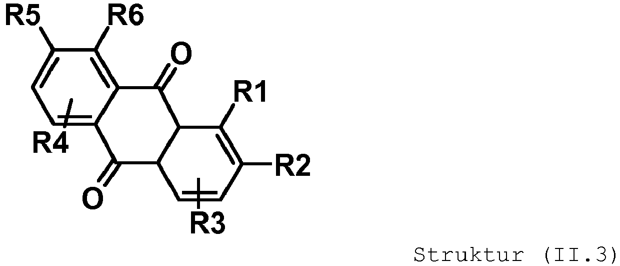
∘ wobei in Struktur (II.3) Ar1 und Ar2 zwei oder mehr verbundene aromatischen oder heteroaromatische Ringe (Ar1, Ar2), bevorzugt Benzolringe, sind, die jeweils mindestens zwei Hydroxygruppen und/oder Aminogruppen umfassen,
∘ R1 bis R6 ausgewählt sind aus H, OH, NH₂;
∘ Y1 ausgewählt ist aus CH, CH₂, CO;
∘ Y2 ausgewählt ist aus CH, CH₂, CO, H;
∘ Z1 ausgewählt ist aus CH, CH₂, CO, O, NH;
∘ Z2 ausgewählt ist aus CH, CH₂, CO, O, NH, H;
∘ wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

6. Organisches optoelektronisches Bauelement nach Anspruch 3, **dadurch gekennzeichnet, dass** die Verbrückung der aromatischen Ringe (Ar1, Ar2), die mittels einer Einfachbindung (-X-) verknüpft sind, 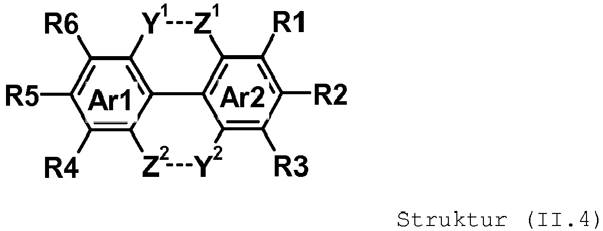
∘ wobei Ar1 und Ar2 zwei oder mehr verbundene aromatischen oder heteroaromatische Ringe (Ar1, Ar2), bevorzugt Benzolringe, sind, die jeweils mindestens zwei Hydroxygruppen und/oder Aminogruppen umfassen,
∘ R1 bis R6 ausgewählt sind aus H, OH, NH2;
∘ Y1 ausgewählt ist aus CH, CH2, CO;
∘ Y2 ausgewählt ist aus CH, CH2, CO, H;
∘ Z1 ausgewählt ist aus CH, CH2, CO, O, NH;
∘ Z2 ausgewählt ist aus CH, CH2, CO, O, NH, H;
∘ Z2 ausgewählt ist aus CH, CH₂, CO, O, NH, H;
∘ wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

7. Organisches, optoelektronischen Bauelement gemäß einem der vorhergehenden Ansprüche, **dadurch gekennzeichnet, dass** die eine Schicht umfassend Verbindungen gemäß einem der vorhergehenden Ansprüche, eine Templatschicht ist, und wobei die Templatschicht vor der Absorberschicht aufgebracht ist.

8. Organisches, optoelektronischen Bauelement gemäß einem der Ansprüche 1 bis 6, **dadurch gekennzeichnet, dass** diese eine Schicht, umfassend Verbindungen gemäß einem der Ansprüche 1 bis 6, eine photoaktive Schicht, also eine Absorberschicht ist, und wobei die Verbindung gemäß einem der Ansprüche 1 bis 6 als Additive der Absorberschicht zugesetzt ist.

9. Organisches optoelektronisches Bauelement gemäß einem der vorhergehenden Ansprüche, wobei das organische optoelektronische Bauelement eine Tandem- oder Mehrfachzelle, umfassend mindestens eine photoaktive Schicht je Zellstruktur, **dadurch gekennzeichnet, dass** mindestens ein Absorbermaterial einer photoaktive Schicht im organischen optoelektronischen Bauelement an eine Verbindung gemäß einem der Ansprüche 1 bis 6 grenzt.

10. Organisches optoelektronischen Bauelement gemäß Anspruch 9, wobei das organische optoelektronische Baueelement verschiedenen Schichten mit gleichen oder unterschiedlichen Verbindungen gemäß Ansprüche 1 bis 6 umfasst.

11. Organisches optoelektronisches Bauelement gemäß einem der vorhergehenden Ansprüche, wobei das organische optoelektronische Bauelement eine organische Solarzelle, oder ein organischer Photodetektor ist und bevorzugt Ellagsäure als Templatmaterial verwendet wird.

12. Herstellung des organischen optoelektrischen Bauelement gemäß einem der vorhergehenden Ansprüche, **dadurch gekennzeichnet, dass** während der Herstellung der Schichten des Schichtstapels des organischen optoelektronischen Bauelements,
a. vor dem Auftragen mindestens einer Absorberschicht die Templatschicht, umfassend mindestens eine der Verbindungen gemäß Ansprüche 1 bis 6 auf den bisher abgeschiedenen Schichtstapel aufgetragen wird, oder
b. dass gleichzeitig mit den Materialien mindestens einer Absorberschicht die Verbindungen gemäß Ansprüche 1 bis 6 auf den bisher aufgebrachten Schichtstapel aufgetragen wird.

13. Verwendung von mindestens einer Verbindung gemäß der Struktur (I) in organisches optoelektronisches Bauelement, umfassend mindestens eine photoaktive Schicht, diese umfassend mindestens ein Absorbermaterialien, **dadurch gekennzeichnet, dass** die Verbindungen gemäß der Struktur (I) an ein Absorbermaterial grenzen: 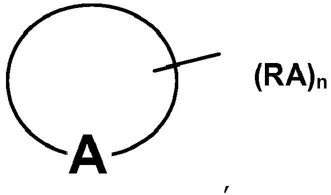
∘ wobei A den Rest eines Zyklus symbolisiert, der ganz oder teilweise ein carbocyclisches oder heterocyclisches aromatisches, monocyclisches oder polycyclisches System bildet,
∘ wobei dieser Zyklus mindestens n > 1 Reste RA umfasst, und diese Reste RA jeweils unabhängig ausgewählt sind aus Hydroxy- und Aminogruppen.

14. Verwendung gemäß Anspruch 13, **dadurch gekennzeichnet, dass** die Absorbermoleküle Moleküle auf der Basis kleiner Moleküle, bevorzugt auf der Basis von A-D-A-Molekülen, sind.

15. Verwendung gemäß Anspruch 13 oder 14, **dadurch gekennzeichnet, dass** Verbindungen gemäß der Ansprüche 1 bis 6 zur Verbesserung der Morphologie angrenzender Absorbermoleküle genutzt, wobei die Verbindungen in einer Templatschicht, die vor der angrenzenden Absorberschicht aufgebracht ist verwendet werden oder gleichzeitig mit der Absorberschicht aufgebracht sind, wobei bevorzugt Ellagsäure als Templatmaterial verwendet wird.
